(19) Europäisches Patentamt

European Patent Office

Office européen des brevets

(11) **EP 0 844 150 B1**

(12) **EUROPÄISCHE PATENTSCHRIFT**

(45) Veröffentlichungstag und Bekanntmachung des Hinweises auf die Patenterteilung:
**12.06.2002 Patentblatt 2002/24**

(51) Int Cl.⁷: **B60R 21/32**, B60R 22/46, B60R 21/13

(21) Anmeldenummer: **97112395.5**

(22) Anmeldetag: **18.07.1997**

(54) **Verfahren zum Erzeugen von Crashsignalen**

Method for generating crash signals

Procédé pour engendrer des signaux d'impact

(84) Benannte Vertragsstaaten:
**DE FR GB**

(30) Priorität: **20.11.1996 DE 19647920**

(43) Veröffentlichungstag der Anmeldung:
**27.05.1998 Patentblatt 1998/22**

(73) Patentinhaber: **ROBERT BOSCH GMBH**
**70442 Stuttgart (DE)**

(72) Erfinder:
• **Maschek, Marko**
**Cambridge, CB39ET (GB)**
• **Henne, Michael**
**74374 Zaberfeld (DE)**

(56) Entgegenhaltungen:
EP-A- 0 590 476        DE-A- 19 644 975
DE-A- 19 713 087     US-A- 5 036 467
US-A- 5 251 161

## Beschreibung

Stand der Technik

Die vorliegende Erfindung betrifft ein Verfahren zum Erzeugen von Signalen, welche verschiedene Crashvorgänge bei Fahrzeugen beschreiben, wobei diese Crashsignale aus einem real gemessenen Crashsignal abgeleitet werden.

Es ist erstrebenswert für jeden Fahrzeugtyp, ein optimales, robustes Auslöseverhalten der darin eingebauten Rückhaltesysteme (Airbags, Gurtstraffer, etc.) zu erreichen. D. h. die Rückhaltesysteme sollen nur dann ausgelöst werden, wenn die Fahrzeuginsassen bei einem Crash auch tatsächlich gefährdet sind und dann soll die Auslösung auch mit sehr großer Sicherheit erfolgen. Ein fehlerhaftes Auslösen von Rückhaltesystemen ist deswegen unerwünscht, weil deren Instandsetzung mit hohen Kosten verbunden ist, insbesondere Versicherungsgesellschaften haben ein großes Interesse daran, daß fehlerhaftes Auslösen von Rückhaltesystemen soweit wie möglich vermieden wird. Der Algorithmus, der das Auslösen von Rückhaltesystemen steuert, muß daher individuell auf jeden Fahrzeugtyp adaptiert werden. Für die Kalibrierung des Auslöse-Algorithmus werden Crashdaten, welche das Verhalten der Fahrzeugkarosserie in den verschiedensten Crashsituationen wiedergeben, herangezogen. Es gibt im wesentlichen drei Kategorien von Crashes, frontale, seitliche und Reparaturcrashes. Mit Reparaturcrashes bezeichnet man solche, durch die ein Rückhaltesystem nicht ausgelöst werden soll, z.B. Rempler beim Einparken. Reparaturcrashes finden bei niedrigen Fahrzeuggeschwindigkeiten ($\leq$15km/h) statt. Die Anzahl der real gefahrenen Crashes eines Fahrzeuges sollte natürlich aus Kostengründen stark limitiert sein. Um aber den Auslöse-Algorithmus möglichst sicher und robust zu gestalten, wäre es wünschenswert, für eine Kalibrierung eine große Zahl von Crashsignalen, welche die unterschiedlichsten Crashsituationen beschreiben, zur Verfügung zu haben.

Aus dem Konferenzpapier von ASL bei SAE, Nr. 920480 (Oberbegriff) ist es bekannt, durch mathematische Methoden aus gemessenen Crashdaten synthetisch neue Crashdaten zu erzeugen, welche andere Crashsituationen beschreiben. Allerdings ist die hier angewandte mathematische Methode zur Herleitung neuer Crashsignale sehr aufwendig und benötigt eine große Rechenzeit. Außerdem korrelieren die nach dem bekannten Verfahren synthetisierten Crashes nur schwach mit real vorkommenden Crashes.

Der Anmeldung liegt daher die Aufgabe zugrunde, ein Verfahren der eingangs genannten Art anzugeben, das es ermöglicht, mit einem möglichst geringen Aufwand an Rechenleistung eine Vielzahl von neuen Crashsignalen zu erzeugen, welche die verschiedensten Crashsituationen darstellen.

Vorteile der Erfindung

Die genannte Aufgabe wird gemäß den Merkmalen des Anspruchs 1 dadurch gelöst, daß aus einem real gemessenen Crashsignal durch Tiefpaßfilterung ein Kernsignal abgeleitet wird, daß das Kernsignal in mehrere zeitlich aufeinander folgende Signalsegmente zerlegt wird, daß jedes Signalsegment durch eine Übertragungsfunktion nachgebildet wird, daß dann alle daraus entstehenden Übertragungsfunktionen zu einer Gesamtübertragungsfunktion zusammengefaßt werden und daß schließlich durch Verändern mindestens eines Parameters der Gesamtübertragungsfunktion ein oder mehrere Crashsignale gebildet werden. Das erfindungsgemäße Verfahren kommt mit einem einzigen real gemessenen Crashsignal aus, um daraus mit einer einfachen mathematischen Methode eine Vielzahl von abgewandelten Crashsignalen herzuleiten.

Zweckmäßige Ausführungen der Erfindung gehen aus den Unteransprüchen hervor.

Beschreibung eines Ausführungsbeispiels

Anhand eines in der Zeichnung dargestellten Ausführungsbeispiels wird nachfolgend die Erfindung näher erläutert. Es zeigen:

Figur 1 ein Ablaufdiagramm für das Verfahren zur Herleitung neuer Crashsignale und

Figur 2 einen Crashsignalverlauf.

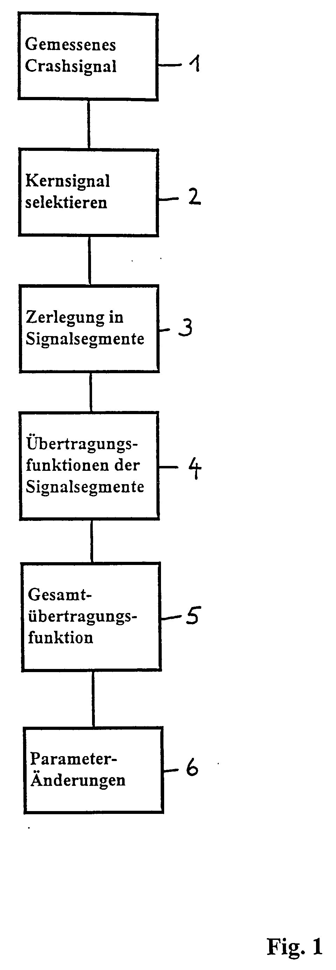

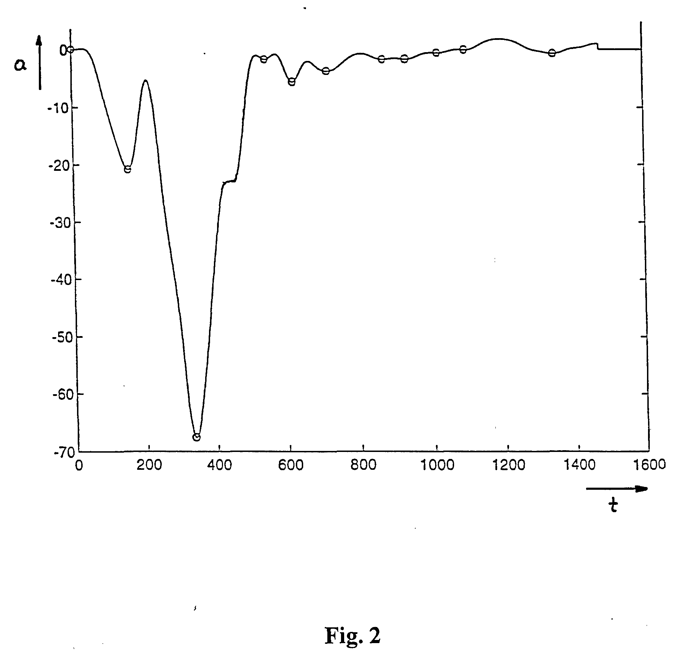

Zur Erzeugung von neuen synthetischen Crashsignalen wird nach Figur 1 in einem ersten Verfahrensschritt 1 ein Crashsignal bei einem real gefahrenen Fahrzeugcrash gemessen und z.B. in Form von ASCII-Daten abgespeichert. In der Figur 2 ist beispielhaft ein an einer bestimmten Stelle im Fahrzeug gemessener Crashsignalverlauf dargestellt. Das Crashsignal stellt die zeitliche Veränderung während eines Crashes der an einer Stelle des Fahrzeugs gemessenen Beschleunigung bzw. Verzögerung a dar. Man erkennt, daß zu Beginn eines Crashes die gemessene Beschleunigung a sehr starke Änderungen erfährt, welche mit zunehmender Zeit abklingen. Die auf der Ordinatenachse der Kurve angegebenen negativen Werte besagen, daß hier die Beschleunigung a negativ ist, d. h. daß das Fahrzeug Verzögerungen beim Aufprall auf einen anderen Gegenstand erfährt. Auf der Abszisse der Kurve ist die Zeit t in Abtastschritten angegeben.

In einem zweiten Verfahrensschritt 2 wird aus dem gemessenen Crashsignal ein Kernsignal selektiert. Dazu wird das gemessene Crashsignal über ein lineares FIR Filter (Filter mit begrenzter Impulsantwort) geführt, das eine Tiefpaßcharakteristik besitzt und eine Grenzfrequenz zwischen 80 und 200 Hz aufweist. Durch diese Filterung werden Signalspitzen kurzer Dauer herausgefiltert, so daß ein geglättetes Kernsignal am Ausgang des Filters übrigbleibt. Der in Figur 2 dargestellte Signalverlauf ist ein solches aus dem gemessenen Crashsignal herausgefiltertes Kernsignal. Dem linearen FIR Filter kann ein nichtlineares Filter (Medianfilter) vorgeschaltet sein, mit dem alle Signalspitzen, die zeitlich gleich oder kürzer als 1ms sind, eliminiert werden. Das Medianfilter führt also eine Vorglättung vor dem linearen FIR Filter durch.

Das Kernsignal wird nun im Verfahrensschritt 3 in mehrere Signalsegmente zerlegt. Die Grenzen der einzelnen Signalsegmente, in der Figur 2 durch Punkte angedeutet, werden zweckmäßigerweise so gelegt, daß jedes Signalsegment ein Impuls aus dem Gesamtsignalverlauf ist. Zur Trennung der einzelnen Impulse werden zunächst mit Hilfe an sich bekannter Signalabtastverfahren Minima und Wendepunkte des Signalverlaufs ermittelt. Ein Impuls liegt jeweils entweder zwischen zwei Minima oder zwischen einem Minimum und einem Wendepunkt. Ob ein solcher Impuls ein geeignetes Signalsegment darstellt, wird durch Vergleich des jeweiligen Impulses mit einem Modellimpuls ermittelt. Der Modellimpuls ist vorteilhafterweise ein durch zwei Parameter veränderbarer Gaußimpuls. Der erste Parameter ist das Pulsbreitenverhältnis rechts und links von der vertikalen Symmetrielinie des Impulses bei einem bestimmten Bruchteil der Gesamtimpulshöhe. Beispielsweise wird bei 75% der Gesamtimpulshöhe ein Vehältnis zwischen den Pulsbreiten rechts und links von der Symmetrielinie von 1:5 vorgegeben. Der zweite Parameter für den Modellimpuls ist das Verhältnis zwischen den Höhen des Impulses an seinen Rändern zu beiden Seiten der Symmetrielinie. Dieses Höhenverhältnis kann z.B. auf 25% festgelegt werden. Nur wenn ein aus dem Signalverlauf selektierter Impuls innerhalb der durch den Modellimpuls vorgegebenen Grenzen bzgl. des Pulsbreiten- und des Pulshöhenverhältnisse liegt, wird er als geeignetes Signalsegment behandelt. Ein Impuls, der diese Voraussetzungen nicht erfüllt, wird dem benachbarten Impuls zugeschlagen und bildet mit ihm zusammen ein Signalsegment.

Im nächsten Verfahrensschritt 4 wird jedes der Signalsegmente durch eine Übertragungungsfunktion in der z-Ebene nachgebildet. Diese Übertragungsfunktion hat z. B. die Form:

$$He\,(z) = \frac{b0 + b1z^{-1} + b2z^{-2}}{1 + a1z^{-1} + a2z^{-2} + a3z^{-3}} \tag{1}$$

Bei dieser Übertragungsfunktion He(z) nach Gleichung (1) werden pro Signalsegment 6 Koeffizienten b0, b1, b2, a1, a2, a3 identifiziert.

Anschließend wird im Verfahrensschritt 5 aus allen einzelnen Übertragungsfunktionen He(z) der Signalsegmente eine Gesamtübertragungsfunktion Hs(z) gebildet.

Diese Gesamtübertragungsfunktion hat folgende Form:

$$Hs\,(z) \;=\; \sum_{i=1}^{s}\sum_{j=0}^{m}\sum_{k=0}^{n} \frac{bjiz^{-1}}{akiz^{-k}}\,z^{-li} \tag{2}$$

Dabei ist i der Laufindex für die Signalsegmente mit s als Anzahl der Segmente,
j der Laufindex für den Zählerkoeffizienten b mit m der Ordnung der Zählerkoeffizienten und
k der Laufindex für den Nennerkoeffizienten a mit n der Ordnung des Nennerkoeffienzenten.
l ist ein Segmentvektor, der von Segment zu Segment durchläuft und angibt, bei welchem Abtastschritt das jeweilige Segment beginnt, dessen Übertragungsfunktion zur Gesamtübertragungsfunktion hizugefügt werden soll.

Im Verfahrensschritt 6 werden durch Parameteränderungen der Gesamtübertragungsfunktion Hs(z) neue Crashsignale erzeugt. Parameteränderung bedeutet, daß die Koeffizienten a in der Gesamtübertragungsfunktion variiert werden. Bei der hier gewählten Übertragungsfunktion He(z) bilden die Koeffizienten a des Nenners der Gesamtübertragungsfunktion Hs(z) ein Polynom dritten Grades in der komplexen z-Ebene. Die Wurzeln dieses Polynoms sind die Pole der Gesamtübertragungsfunktion. Da der Polynom dritten Grades ist, gibt es einen reellen Pol und ein konjugiert komplexes Polpaar. Durch Verändern des Ortes mindestens eines komplexen Pols innerhalb des Einheitskreises in der komplexen z-Ebene - der Einheitskreis beschreibt die Stabilitätsgrenze - erhält man neue Crashsignalverläufe.

Eine Variation der Nullstellen, also der Koeffizienten b im Zähler, ist unbrauchbar, da sie keinen Einfluß auf das Frequenzspektrum der Gesamtübertragungsfunktion Hs(z) hat, sondern sich nur auf deren Amplitude auswirkt. Diese Variation würde ausschließlich neue Crashsignale mit veränderter Amplitude hervorbringen, aber nicht die Crashsignale in ihrer Form verändern.

Das Maß der Variation der Nennerkoeffizienten a der Gesamtübertragungsfunktion Hs(z), um möglichst realitätsnahe neue Crashsignale zu generieren, orientiert sich an Berechnungen der Korrelation und der Energieabweichung (Abweichung der Effektivwerte) zwischen synthetischen Crashsignalen und realen Crashsignalen. Variationen von 0.1 bis 1.0% führen erfahrungsgemäß zu synthetischen Crashsignalen, welche eine enge Korrelation zu realen Crashes haben.

Abweichend von dem zuvor beschriebenen Ausführungsbeispiel kann anstelle einer Übertragungsfunktion dritter Ordnung auch eine mit noch höherer Ordnung verwendet werden. Ebenso kann eine Übertragungsfunktion nur zweiter Ordnung in Frage kommen.

Das hier zugrundeliegende Verfahren ermöglicht es, aus Kernsignalen mit einer recht hohen Filtereckfrequenz bis zu 200Hz neue Crashsignale abzuleiten. Dadurch ist gewährleistet, daß wichtige Informationen des real gemessenen Crashsignals bei der Generierung synthetischer Crashsignale erhalten bleiben.

Das real gemessene Crashsignal setzt sich zusammen aus dem durch Filterung selektierten Kernsignal und einem Restsignal. Auch das Restsignal kann variiert und dem variierten Kernsignal zur Synthetisierung neuer Crashsignale überlagert werden.

**Patentansprüche**

1. Verfahren zum Erzeugen von Signalen, welche verschiedene Crashvorgänge bei Fahrzeugen beschreiben, wobei diese Crashsignale aus einem real gemessenen Crashsignal abgeleitet werden, **dadurch gekennzeichnet,**

   - **daß** aus dem real gemessenen Crashsignal durch Tiefpaßfilterung ein Kernsignal abgeleitet wird,
   - **daß** das Kernsignal in mehrere zeitlich aufeinander folgende Signalsegmente zerlegt wird,
   - **daß** jedes Signalsegment durch eine Übertragungsfunktion nachgebildet wird,
   - **daß** alle daraus entstehenden Übertragungsfunktionen zu einer Gesamtübertragungsfunktion zusammengefaßt werden,
   - und **daß** durch Verändern mindestens eines Parameters der Gesamtübertragungsfunktion ein oder mehrere neue Crashsignale gebildet werden.

2. Verfahren nach Anspruch 1, **dadurch gekennzeichnet, daß** das Kernsignal in Einzelimpulse zerlegt wird, welche die einzelnen Signalsegmente darstellen.

3. Verfahren nach Anspruch 1 oder 2, **dadurch gekennzeichnet, daß** die Signalsegmente durch Vergleich der Einzelimpulse mit einem Modellimpuls bestimmt werden, daß der Modellimpuls ein durch mehrere Parameter veränderbarer Gaußimpuls ist und daß ein Einzelimpuls dann als eigenes Signalsegment akzeptiert wird, wenn der Einzelimpuls innerhalb vorgebbarer Grenzen relativ zum Modellimpuls liegt.

4. Verfahren nach Anspruch 1,2 oder 3, **dadurch gekennzeichnet, daß** die einzelnen Signalsegmente durch eine Übertragungsfunktion in der komplexen z-Ebene von der Form

$$He\ (z) = \frac{b0 + b1z^{-1} + b2z^{-2}}{1 + a1z^{-1} + a2z^{-2} + a3z^{-3}}$$

nachgebildet werden.

5. Verfahren nach Anspruch 1 oder 4, **dadurch gekennzeichnet, daß** die Gesamtübertragungsfunktion die Form

$$Hs\ (z)\ =\ \sum_{i=1}^{s}\sum_{j=0}^{m}\sum_{k=0}^{n}\frac{bjiz^{-1}}{akiz^{-k}}z^{-li}$$

hat, wobei i der Laufindex für die Signalsegmente mit s als Anzahl der Segmente,
j der Laufindex für den Zählerkoeffizienten b mit m der Ordnung des Zählerkoeffizienten,
k der Laufindex für den Nennerkoeffizienten a mit n der Ordnung des Nennerkoeffizienten und
l ein Vektor ist, der die Grenzen der Signalsegmente angibt.

**6.** Verfahren nach Anspruch 5, **dadurch gekennzeichnet, daß** zur Bildung neuer Crashsignale mindestens ein komplexer Pol in der Gesamtübertragungsfunktion geändert wird.

**Claims**

**1.** Method for generating signals which describe various crash events involving vehicles, these crash signals being derived from an actually measured crash signal, **characterized**

- **in that** a core signal is derived from the actually measured crash signal by means of lowpass filtering,
- **in that** the core signal is decomposed into a plurality of temporally sequential signal segments,
- **in that** each signal segment is simulated by a transfer function,
- **in that** all transfer functions produced therefrom are combined to form an overall transfer function,
- and **in that** one or more new crash signals are formed by varying at least one parameter of the overall transfer function.

**2.** Method according to Claim 1, **characterized in that** the core signal is decomposed into individual pulses which represent the individual signal segments.

**3.** Method according to Claim 1 or 2, **characterized in that** the signal segments are determined by comparing the individual pulses with a model pulse, **in that** the model pulse is a Gaussian pulse which can be varied by a plurality of parameters, and **in that** an individual pulse is accepted as its own signal segment whenever the individual pulse is situated within prescribable bounds relative to the model pulse.

**4.** Method according to Claim 1, 2 or 3, **characterized in that** the individual signal segments are simulated by means of a transfer function in the complex z-plane of form

$$He(z) = \frac{b0 + b1z^{-1} + b2z^{-2}}{1 + a1z^{-1} + a2z^{-2} + a3z^{-3}}$$

**5.** Method according to Claim 1 or 4, **characterized in that** the overall transfer function has the form of

$$Hs(z) = \sum_{i=1}^{s} \sum_{j=0}^{m} \sum_{k=0}^{n} \frac{bjiz^{-1}}{akiz^{-k}} z^{-li}$$

i being the running index for the signal segments, with s as the number of segments,
j being the running index for the numerator coefficient b, with m as the order of the numerator coefficient,
k being the running index for the denominator coefficient a, with n as the order of the denominator coefficient, and
l being a vector which specifies the bounds of the signal segments.

**6.** Method according to Claim 5, **characterized in that** at least one complex pole is changed in the overall transfer function in order to form new crash signals.

**Revendications**

**1.** Procédé pour générer des signaux décrivant différentes phases de collision de véhicule, selon lequel on déduit ces signaux de collision d'un signal de collision réellement mesuré,

**caractérisé en ce qu'**

- à partir du signal de collision réellement mesuré on déduit un signal de base par filtrage par un filtre passe-bas,
- on décompose le signal de base en plusieurs segments de signal qui se suivent dans le temps,
- on copie chaque segment de signal par une fonction de transfert,
- on réunit toutes les fonctions de transfert obtenues en une fonction de transfert globale, et
- en modifiant au moins un paramètre de la fonction de transfert globale on forme un ou plusieurs nouveaux signaux de collision.

2. Procédé selon la revendication 1,
   **caractérisé en ce qu'**
   on décompose le signal de collision en impulsions séparées que représentent les différents segments de signal.

3. Procédé selon l'une quelconque des revendications 1 ou 2,
   **caractérisé en ce qu'**
   on détermine les segments de signal par comparaison des impulsions séparées à une impulsion modèle,
   l'impulsion modèle est une impulsion de Gauss à plusieurs paramètres modifiables, et
   on accepte une impulsion séparée comme segment de signal propre si l'impulsion séparée se situe dans des limites prédéterminées par rapport à l'impulsion modèle.

4. Procédé selon l'une quelconque des revendications 1, 2 ou 3,
   **caractérisé en ce qu'**
   on copie les différents segments de signal par une fonction de transfert dans le plan complexe (z), cette fonction de transfert ayant la forme suivante :

$$He(z) = \frac{b0 + b1z^{-1} + b2z^{-2}}{1 + a1z^{-1} + a2z^{-2} + a3z^{-3}}$$

5. Procédé selon l'une quelconque des revendications 1 ou 4,
   **caractérisé en ce que**
   la fonction de transfert globale a la forme suivante :

$$Hs(z) = \sum_{i=1}^{5} \sum_{j=0}^{m} \sum_{k=0}^{n} \frac{bjiz^{-1}}{akiz^{-k}} z^{-li} \qquad (2)$$

i est l'indice courant des segments de signal,
avec s le nombre de segments,
j est l'indice courant des coefficients de compteur b avec m l'ordre des coefficients de compteur, et
k est l'indice courant des coefficients du dénominateur a avec n l'ordre des coefficients du dénominateur, et
l est un vecteur qui indique les limites des segments de signal.

6. Procédé selon la revendication 5,
   **caractérisé en ce qu'**
   on modifie un pôle complexe de la fonction de transfert globale pour former de nouveaux signaux de collision.

Gemessenes
Crashsignal — 1

Kernsignal
selektieren — 2

Zerlegung in
Signalsegmente — 3

Übertragungsfunktionen der
Signalsegmente — 4

Gesamtübertragungsfunktion — 5

Parameter-
Änderungen — 6

**Fig. 1**

**Fig. 2**